(19) **Europäisches Patentamt / European Patent Office / Office européen des brevets**

(11) **EP 3 714 199 B1**

(12) **FASCICULE DE BREVET EUROPEEN**

(45) Date de publication et mention
de la délivrance du brevet:
**27.10.2021 Bulletin 2021/43**

(21) Numéro de dépôt: **18825750.5**

(22) Date de dépôt: **20.11.2018**

(51) Int Cl.:
*F16P 3/00* (2006.01)   *B26D 7/22* (2006.01)
*B26D 7/24* (2006.01)   *B25F 5/00* (2006.01)
*A01G 3/037* (2006.01)   *F16P 3/12* (2006.01)
*H03K 17/96* (2006.01)   *B26B 15/00* (2006.01)
*F16P 3/20* (2006.01)

(86) Numéro de dépôt international:
**PCT/FR2018/052912**

(87) Numéro de publication internationale:
**WO 2019/102127 (31.05.2019 Gazette 2019/22)**

(54) **OUTIL DE COUPE ÉLECTRIQUE À ARRÊT D'URGENCE AUTOMATIQUE**

ELEKTROSCHNEIDWERKZEUG MIT AUTOMATISCHEM NOTSTOPP

ELECTRIC CUTTING TOOL WITH AUTOMATIC EMERGENCY STOP

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **23.11.2017 FR 1771254**

(43) Date de publication de la demande:
**30.09.2020 Bulletin 2020/40**

(73) Titulaire: **Pellenc**
**84120 Pertuis (FR)**

(72) Inventeurs:
• **PELLENC, Roger**
**84120 Pertuis (FR)**
• **LOPEZ, Bernard**
**84240 La Tour D'Aigues (FR)**

(74) Mandataire: **Weber, Etienne Nicolas**
**Cabinet Marek**
**28, rue de la Loge**
**Boîte Postale 42413**
**13201 Marseille Cedex 02 (FR)**

(56) Documents cités:
**FR-A1- 2 712 837    FR-A1- 2 838 998**

Il est rappelé que: Dans un délai de neuf mois à compter de la publication de la mention de la délivrance du brevet européen au Bulletin européen des brevets, toute personne peut faire opposition à ce brevet auprès de l'Office européen des brevets, conformément au règlement d'exécution. L'opposition n'est réputée formée qu'après le paiement de la taxe d'opposition. (Art. 99(1) Convention sur le brevet européen).

EP 3 714 199 B1

## Description

## Domaine technique

La présente invention concerne un outil de coupe sécurisé à commande électrique pourvu d'un dispositif d'arrêt d'urgence automatique. Le dispositif d'arrêt d'urgence vise à empêcher une blessure grave d'un utilisateur de l'outil de coupe en cas de contact inopiné de l'utilisateur avec un organe de coupe de l'outil de coupe, lorsque l'outil est en fonctionnement. Pour le moins, l'invention vise à limiter une éventuelle blessure à une blessure légère.

Une blessure grave est caractérisée, par exemple, pour un sécateur électrique, par une coupe profonde, voire la section complète d'une partie d'un doigt de l'utilisateur. Une blessure légère peut, en revanche, être comparée à une griffure de l'épiderme de la main dans des ronces pouvant générer un léger écoulement de sang.

Le dispositif d'arrêt d'urgence est considéré comme étant automatique si l'arrêt d'urgence est déclenché sans intervention volontaire de l'utilisateur, mais à la simple détection d'une situation de risque de blessure.

L'invention peut trouver des applications pour différents outils de coupe, et en particulier pour des outils de coupe électroportatifs à lame mobile, tels que des sécateurs ou des cisailles, voire des tronçonneuses, des scies circulaires, des perceuses ou des meuleuses.

## Etat de la technique antérieure

Une Illustration de rétat de la technique est donnée par les documents suivants :

FR2 712 837
FR2 779 669
FR2 831 476
FR2 838 998
FR2 848 729
FR2 963 081
FR3 001404
EP2 490 865
EP2 825 811
US5 025 175
US7 365 955

Ces documents concernent des machines et des outils, à commande électrique, pourvus d'un dispositif d'arrêt d'urgence pour éviter qu'un utilisateur ne se blesse. Parmi ces documents on peut constater de nombreux outils comme des sécateurs électriques tenus à une seule main pour couper de la végétation. Notamment le document FR 2 712 837 divulgue un outil de coupe motorisé selon le préambule de la revendication 1.

Dans cet exemple, les utilisateurs tiennent le sécateur électrique à une main et utilisent leur deuxième main, libre, pour la manipulation des végétaux coupés ou à couper. Un risque de blessure existe alors lorsque la main qui ne tient pas le sécateur vient à proximité immédiate ou en contact avec l'organe de coupe lors de la coupe. Dans le cas des sécateurs ou des cisailles, l'organe de coupe, se présente majoritairement sous la forme d'une lame fixe, ou crochet, et d'une lame pivotante. La lame pivotante pivote entre une position ouverte et une position refermée sur le crochet, avec un effet de cisaillement entre la lame pivotante et le crochet. L'organe de coupe de certains sécateurs peut aussi consister en deux lames mobiles coopérant entre elle pour réaliser l'effet de cisaillement lorsque les lames passent d'une position ouverte à une position refermée.

Dans le cas des perceuses, des meuleuses, des scies circulaires ou des tronçonneuses, l'organe de coupe présente des parties tranchantes en rotation autour d'un axe.

Dans le cas de machines-outils telles que des cisailles, des broyeurs ou des scies circulaires, des organes de coupe se présentent sous la forme de parties tranchantes en rotation autour d'un axe ou en translation par rapport à un bâti fixe.

Différents moyens sont mis en œuvre pour détecter la proximité immédiate ou le contact de la main avec l'organe de coupe. On peut distinguer notamment des moyens radioélectriques, des moyens à détection de potentiel sur la lame, des moyens capacitifs ou encore des moyens à mesure d'impédance.

Les dispositifs de sécurité connus mettent en œuvre des gants, des chaussures ou encore une balise, reliés électriquement au dispositif de sécurité par un lien de communication. Le lien peut être un lien par fil ou éventuellement par voie hertzienne.

Lorsque des gants sont utilisés, les gants sont pourvus de conducteurs électriques et ont pour fonction de créer un circuit de mesure entre le gant et l'organe de coupe. Similairement, des chaussures conductrices peuvent être utilisées pour créer un circuit de mesure relié à la terre et incluant le corps de l'utilisateur.

L'utilisation de balises électroniques, de gants conducteurs, de chaussures conductrices, ou plus généralement d'un vêtement conducteur relié électriquement à l'outil de coupe, permet de détecter un contact de l'utilisateur avec l'organe de coupe. Un arrêt d'urgence de l'opération de coupe, en réponse, par exemple, à la détection du contact du vêtement conducteur avec l'organe de coupe, permet d'éviter ou de limiter la gravité d'une blessure éventuelle.

Les dispositifs de sécurité connus présentent cependant un certain nombre de difficultés ou d'inconvénients pour l'utilisateur. Parmi celles-ci on peut relever notamment :

- la gêne occasionnée par le port de vêtements conducteurs, et en particulier de gants conducteurs,
- la gêne occasionnée par un lien filaire entre les vêtements conducteurs et le sécateur,
- un risque de sectionner le lien filaire entre le vêtement conducteur et le sécateur,

- un risque de blessure en cas d'oubli du port du vêtement conducteur ou de la balise de détection, ou d'un port inadéquat de ces accessoires.

- un risque lié à la défaillance des contacts entre le dispositif de sécurité et l'organe de coupe. Par exemple, l'usure des gants conducteurs suite à une trop longue utilisation, un mauvais entretien, une détérioration accidentelle, voire le dépôt de substances isolantes au niveau du gant ou de l'organe de coupe, telles que de la sève, de l'huile ou de la graisse, risquent de modifier voire d'occulter le signal perçu par le dispositif de sécurité. Ceci peut, à court terme, rendre inopérant le dispositif de sécurité sans que l'utilisateur ne s'en rende compte au préalable.

**Exposé de l'invention**

La présente invention a pour but de proposer un outil de coupe sécurisé qui ne présente pas les inconvénients mentionnés ci-dessus.

En effet, l'invention a pour but de proposer un outil de coupe sécurisé qui ne fasse pas appel à un vêtement conducteur électrique tel qu'un gant et qui ne nécessite pas le port d'une balise.

L'Invention propose un outil de coupe comportant un dispositif de sécurité qui utilise simplement la conductivité du corps de l'utilisateur à proximité immédiate ou en contact avec celui-ci, pour détecter l'existence d'un contact entre l'utilisateur et l'organe de coupe, et ainsi prévenir d'un risque de blessure.

L'utilisation de la simple conductivité du corps humain, mesurable par son impédance notamment, présente cependant des difficultés tenant à la qualité de contact électrique entre le corps de l'utilisateur et le dispositif de sécurité ou l'organe de coupe. L'Impédance intrinsèque du corps humain est en effet de faible valeur et ne varie pas. Tel n'est pas le cas d'une impédance de contact entre le corps de l'utilisateur et une partie conductrice comme, par exemple, une électrode de contact manuel ou le tranchant d'une lame de coupe conductrice. Cette impédance est susceptible en effet de varier dans des proportions importantes. Elle peut varier selon les caractéristiques de la peau de l'utilisateur, selon le fait que la peau soit mouillée ou non, selon les caractéristiques de surface d'une l'électrode de contact manuel (dimensions, rugosité, conductivité...), selon les conditions climatiques ou encore selon une pression de contact exercée par l'utilisateur.

Par exemple, une main avec une peau sèche a une très faible conductivité. Son contact, avec une faible pression, sur une électrode de contact manuel peut générer une grande impédance de contact pouvant atteindre des valeurs de quelques centaines de milliers d'Ohms. A l'inverse, le contact avec une main humide, notamment en atmosphère saline en bord de mer, apporte une faible Impédance de contact de quelques milliers d'Ohms, voire seulement quelques centaines d'Ohms ou même quelques Ohms.

Le contact d'une partie du corps d'un utilisateur avec l'organe de coupe, peut se traduire par une valeur d'Impédance de quelques Ohms voire quelques centaines d'Ohms selon la pression de contact exercée s'il a lieu, par exemple, dans une zone très conductrice et coupante comme le tranchant de la lame d'un sécateur. En revanche, la valeur d'impédance peut être de quelques centaines d'Ohms, voire de quelques milliers d'ohms, ou plus, si le contact a lieu sur une autre partie de l'organe de coupe, par exemple sur le côté d'une lame de coupe possédant un revêtement isolant mince.

Ces aléas, peuvent être obviés par l'usage d'un vêtement et/ou d'un lien filaire conducteur électrique aboutissant à une impédance de contact ne variant que sur une faible plage de valeurs. Si ce n'est le cas, ils doivent être pris en compte de manière à ne pas compromettre la sécurité de l'outil de coupe.

En effet, le contact d'un utilisateur simultané avec un dispositif de sécurité et un organe de coupe peut générer une très grande plage de valeurs d'impédances possibles entre l'organe de coupe et l'outil comportant le dispositif de sécurité. Il n'est pas possible, dans ce cas, d'établir de façon fiable le risque d'un contact réel entre l'utilisateur et l'organe de coupe.

Pour surmonter ces difficultés, la présente invention propose un outil de coupe sécurisé comprenant:

- un organe de coupe conducteur électrique,
- un moteur d'actionnement de l'organe de coupe commandé électriquement,
- une poignée de saisie de l'outil de coupe par la main d'un utilisateur, la poignée de saisie étant électriquement isolée de l'organe de coupe,
- une commande de déclenchement de coupe, actionnable par la main de l'utilisateur saisissant la poignée de saisie, la commande de déclenchement de coupe étant électriquement isolée de l'organe de coupe et
- un dispositif d'arrêt d'urgence sensible à un contact de l'utilisateur avec l'organe de coupe.

Conformément à l'invention l'outil se caractérise par :

- au moins une première et au moins une deuxième électrode de contact manuel, la première électrode de contact manuel et la deuxième électrode de contact manuel étant électriquement isolées l'une de l'autre, et ménagées sur au moins l'une de la poignée et de la commande de déclenchement de coupe,
- un premier circuit électrique comprenant la première électrode de contact manuel, une première impédance électrique et l'organe de coupe, le premier circuit électrique étant susceptible d'être fermé, lors d'un contact simultané de l'utilisateur avec ladite première électrode de contact manuel et l'organe de coupe,
- un deuxième circuit électrique comprenant la première et la deuxième électrode de contact manuel, la première impédance électrique et une deuxième impédance électrique, le deuxième circuit électrique étant susceptible d'être fermé lors d'un contact simultané de l'utilisateur avec la première et la deuxième électrode de contact manuel,

- au moins un dispositif de mesure d'une caractéristique d'impédance du premier circuit électrique et d'une caractéristique d'Impédance du deuxième circuit électrique,

- un comparateur de la caractéristique d'Impédance du premier circuit électrique et d'au moins une caractéristique de seuil fonction de la caractéristique d'impédance du deuxième circuit électrique,

- le comparateur est relié au dispositif d'arrêt d'urgence, pour provoquer l'arrêt d'urgence de l'outil de coupe en cas de franchissement de la caractéristique de seuil.

On considère que la poignée et/ou la commande de déclenchement de coupe sont électriquement isolés de l'organe de coupe lorsqu'au moins une partie de la poignée et/ou de la commande de déclenchement de coupe portant les électrodes de contact manuel, et touchées par l'utilisateur tenant la poignée, sont électriquement isolées de l'organe de coupe, ou sont reliés à l'organe de coupe par l'intermédiaire d'une impédance avec une valeur supérieure de plusieurs ordres de grandeur aux valeurs des impédances en jeu dans le fonctionnement du dispositif de sécurité de l'outil de coupe, par exemple une valeur de plusieurs millions d'Ohms.

Le dispositif d'arrêt d'urgence est piloté par le comparateur pour provoquer un arrêt d'urgence. On entend par "arrêt d'urgence" le déclenchement immédiat de l'une des opérations suivantes :

- la coupure de l'alimentation du moteur d'actionnement,

- un freinage d'urgence agissant sur le moteur d'actionnement et/ou directement sur l'organe de coupe

- le déclenchement d'un mouvement d'urgence de l'outil de coupe, tel que, par exemple, l'ouverture de l'organe de coupe, dans le cas d'un sécateur ou d'une cisaille ou un mouvement de compensation de l'inertie cinétique des pièces mobiles de l'organe de coupe.

Lorsque le moteur d'actionnement est un moteur électrique, le freinage, électromagnétique, le déclenchement d'un mouvement d'urgence, voire la simple coupure de l'alimentation, peuvent avoir lieu par l'intermédiaire d'une carte électronique de commande du moteur.

L'outil de coupe de l'invention peut être en particulier l'un parmi un sécateur, une cisaille, une perceuse, une meuleuse, une scie circulaire, une tronçonneuse ou toute autre outil ou machine-outil possédant un organe de coupe à sécuriser. Ainsi, la mention d'un sécateur dans la description qui suit, par commodité de langage ou par simplification, ne préjuge pas de la nature de l'outil de coupe.

On entend par "caractéristique d'impédance", une valeur de tension, de courant, une valeur ohmique, ou plus généralement une caractéristique électrique liée respectivement à l'impédance du premier circuit électrique et du deuxième circuit électrique. Elle est établie par le dispositif de mesure. La caractéristique de seuil peut également être une valeur de tension, de courant ou une valeur ohmique fonction de la caractéristique d'impédance du deuxième circuit. Elle peut notamment être proportionnelle à la caractéristique d'Impédance du deuxième circuit électrique ou égale à cette caractéristique dimpédance.

L'outil de coupe de l'invention fait appel à au moins une paire d'électrodes de contact manuel comprenant la première et la deuxième électrode de contact manuel. Les électrodes de contact manuel sont prévues pour un contact électrique avec la main de l'utilisateur qui saisit la poignée de saisie pour commander l'outil. Elles peuvent être disposées, en étant isolées l'une de l'autre, sur la poignée de saisie ou sur la commande de déclenchement de coupe, telle que la gâchette de commande de la coupe d'un sécateur électrique, la partie de la gâchette comportant l'électrode étant isolée de l'organe de coupe.

La commande de déclenchement de coupe n'est pas nécessairement une commande à gâchette. Il peut aussi s'agir d'une commande optique détectant la présence d'un doigt, par exemple. Les termes "commande de déclenchement de coupe" sont compris comme incluant de manière générale un organe convenant au déclenchement de la coupe ou convenant plus généralement à provoquer le fonctionnement du moteur d'actionnement de l'outil de coupe.

Bien que la description se réfère à deux électrodes, un nombre plus grand d'électrodes de contact manuel peut cependant être utilisé. Dans la suite de la description, une référence à la première ou à la deuxième électrode de contact manuel ne préjuge pas du caractère unique ou multiple de ces électrodes. L'utilisation de plusieurs premières électrodes de contact manuel et de plusieurs deuxièmes électrodes de contact manuel peut être envisagée notamment pour améliorer un contact électrique avec la main de l'utilisateur.

Les termes "première impédance" ou "deuxième impédance" désignent respectivement un ou plusieurs composants électroniques pouvant comporter une composante résistive mais également une composante inductive et/ou une composante capacitive. Dans une réalisation préférée, la première impédance et la deuxième impédance peuvent être formées chacune par un composant électronique tel qu'une résistance électrique de valeur définie. La première impédance et la deuxième Impédance présentent ainsi des valeurs ohmiques fixes et connues.

Lorsque l'utilisateur tient la poignée de l'outil avec l'une de ses mains, lors de l'utilisation de l'outil, la main vient en contact avec la première électrode de contact manuel et avec la deuxième électrode de contact manuel. Les électrodes de contact manuel peuvent être des électrodes métalliques, conductrices électriques, ou peuvent être formées par des plages de matière plastique de la poignée ou de la gâchette, également conductrices électriques. Il s'agit, par exemple, d'électrodes faites d'un polymère conducteur intrinsèque tel que le Polypyrolle, ou d'une matière plastique conductrice extrinsèque chargée, par exemple, de particules de carbone ou d'argent.

Le contact simultané de la main avec la première et la deuxième électrode de contact manuel, permet de relier électriquement ces électrodes par l'intermédiaire de la main de l'utilisateur, avec une impédance correspondant essentiellement à la somme des impédances de contact entre la main et chacune de la première électrode et de la deuxième électrode de contact manuel.

Pour garantir un bon contact physique et électrique, la première électrode de contact manuel et la deuxième électrode de contact manuel peuvent être disposées sur des côtés opposés de la poignée de saisie. Elles peuvent notamment être disposées sur le dessus et le dessous de la poignée, le dessus de la poignée étant généralement orienté vers la partie de la main de l'utilisateur la plus proche du bras tandis que le dessous de la poignée est généralement orienté vers l'extrémité des doigts dans le cas d'un sécateur électrique. La première électrode de contact manuel peut aussi être disposée sur la gâchette de la commande de l'opération de coupe, si une gâchette est prévue.

On comprend ainsi que la main de l'utilisateur présente une partie différente en contact avec chacune des électrodes de contact manuel et ainsi une impédance de contact qui peut être différente avec chaque électrode de contact manuel. Chacune de ces impédances dépend aussi de l'état de la main de l'utilisateur, de sa pression sur les électrodes, de la surface des électrodes et aussi des conditions ambiantes.

En négligeant l'impédance propre des électrodes de contact manuel et du câblage, les impédances de contact de la main avec chacune des électrodes de contact manuel se trouvent en série avec la première impédance électrique et la deuxième impédance électrique dans le deuxième circuit électrique. Les valeurs de la première et de la deuxième impédance électrique sont connues et fixées lors de la fabrication du sécateur.

Le dispositif de mesure d'une caractéristique d'impédance du deuxième circuit en donne une valeur caractérisant la somme de ces impédances.

Le premier circuit électrique, qui comprend la première électrode de contact manuel, la première impédance électrique et l'organe de coupe, reste un circuit ouvert lorsque l'utilisateur prend en main la poignée de saisie de l'outil. Or, lorsqu'il est ouvert, l'impédance totale du premier circuit électrique est quasi infinie, donc forcément supérieure à l'impédance du deuxième circuit électrique.

Le premier circuit électrique est en revanche fermé lorsque l'utilisateur touche simultanément l'organe de coupe conducteur électrique et la première électrode de contact manuel. Dans la suite de la description, on considère, par simplification, que l'utilisateur touche l'organe de coupe avec un doigt de la main qui ne saisit pas l'outil de coupe. L'évocation dans la suite de la description du doigt qui touche l'organe de coupe ne préjuge cependant pas de la partie du corps susceptible de toucher l'organe de coupe. Le fonctionnement du dispositif de sécurité de l'invention est en effet identique lors d'un contact d'une autre partie du corps de l'utilisateur, tel que le visage, l'avant-bras, la jambe ou la main libre, avec l'organe de coupe. Lorsque le premier circuit électrique est fermé par un contact inopiné du doigt avec l'organe de coupe, associé au contact de la main avec la première électrode de contact manuel, la première impédance, l'impédance de contact de la main avec la première électrode de contact manuel, l'impédance du corps de l'utilisateur entre sa main tenant la poignée et le doigt touchant l'organe de coupe, l'impédance de contact du doigt avec l'organe de coupe, et l'organe de coupe se trouvent reliés en série dans le premier circuit électrique.

Ainsi le dispositif de mesure d'une caractéristique d'Impédance du premier circuit électrique donne une valeur de la somme de ces Impédances.

On estime que l'impédance des électrodes, du câblage et celle de l'organe de coupe sont négligeables. L'ordre de grandeur de l'impédance du corps de l'utilisateur, entre sa première main amenée à saisir la poignée et son doigt de l'autre main amené à toucher l'organe de coupe, est par ailleurs connue dans l'état de l'art. Il s'agit de la conductivité du corps humain dont l'impédance a une valeur Inférieure à dix mille Ohms, et en tous cas d'un ordre de grandeur de mille Ohms. Par contre, impédance de contact de la main avec la ou les électrodes de contact manuel, dans le premier et dans le deuxième circuit électrique ainsi que la valeur de l'Impédance de contact entre le doigt et l'organe de coupe peuvent présenter une grande variabilité et sont le plus souvent très supérieures à la valeur de l'Impédance du corps de l'utilisateur, notamment en cas de pression de contact faible et d'une peau de la main ayant une faible conductivité. Or, quand le contact du doigt avec l'organe de coupe est proche d'un risque de blessure, les différents essais conduits par la déposante montrent que la valeur de l'impédance de contact du doigt peut être évaluée comme étant du même ordre de grandeur voire inférieure à la valeur de l'impédance du corps de l'utilisateur. En effet, le doigt présente une élasticité importante lorsque la lame vient à son contact et ce n'est qu'avec une pression significative que la lame peut d'abord couper l'épiderme du doigt provoquant une blessure légère avant d'effectuer une blessure grave en poursuivant la coupe. Dans ce dernier cas, de coupure légère, comme une griffure au niveau de l'épiderme, la valeur de l'impédance de contact entre l'organe de coupe et les parties sous-cutanées du corps est alors très inférieure à la valeur de l'impedance du corps humain.

On en déduit donc que la valeur de l'impédance de contact au niveau de l'organe de coupe en cas de contact sérieux est inférieure à la valeur de l'impédance du corps humain. Une détection d'une impédance de cet ordre de grandeur permet alors d'identifier avec une très grande probabilité l'existence d'un contact instantané et non souhaité de l'utilisateur avec l'organe de coupe.

Il n'en est pas de même de l'impédance de contact entre la main de l'utilisateur et de la première électrode de contact manuel, dont la valeur peut varier dans des proportions plus importantes. De fait, la simple mesure de la caractéristique d'impédance du premier circuit ne permet pas d'identifier l'existence d'un contact entre l'utilisateur et l'organe de coupe. Dès qu'il y a une blessure légère, l'impédance de contact chute alors très rapidement à une valeur inférieure à l'impédance du corps humain et elle chute encore lorsqu'il y a une coupe profonde pour atteindre une valeur très faible de quelques centaines d'Ohms. L'impédance de seuil caractéristique d'un tel contact, compte tenu de sa valeur globalement faible et en tous cas estimée à un ordre de grandeur inférieur à l'impédance du corps humain, est largement masquée par les variations possibles de l'impédance de contact entre la main de l'utilisateur et la première électrode de contact manuel. On ne peut donc ainsi caractériser de façon fiable l'existence d'un risque de contact au niveau de l'organe de coupe par une simple mesure de la caractéristique d'impédance du premier circuit.

Il est donc très important pour la fixation d'une valeur seuil permettant d'établir la certitude d'un contact entre le doigt de l'utilisateur et l'organe de coupe de s'affranchir des variations de la caractéristique de contact entre la main de l'utilisateur et la première électrode de contact manuel.

Ceci a lieu, conformément à l'invention, en fixant une caractéristique de seuil à partir de la caractéristique d'impédance du deuxième circuit. Il est ainsi possible de confronter l'Impédance du premier circuit électrique à celle de la deuxième impédance, en s'affranchissant de l'influence de l'impédance de contact de la main avec les électrodes de contact manuel et notamment l'Impédance de contact de la main avec la première électrode de contact manuel. En cas de passage d'une valeur d'impédance élevée du premier circuit électrique vers une valeur plus faible que le seuil déterminé à partir de la mesure effectuée sur le deuxième circuit électrique, on détermine alors l'existence d'un risque très élevé de contact entre l'utilisateur et l'organe de coupe. Le dispositif d'arrêt d'urgence est alors actionné.

Comme indiqué, la caractéristique de seuil est fixée en fonction de la caractéristique d'impédance du deuxième circuit électrique qui sert de circuit de référence.

L'impédance du deuxième circuit électrique est égale à la somme de la première impédance, de la deuxième Impédance et des impédances de contact de la main sur les électrodes de contact manuel. La somme de la première impédance et deuxième impédance est de préférence fixée à une valeur supérieure à la somme d'une impédance estimée du corps de l'utilisateur et d'une impédance estimée de contact du doigt sur l'organe de coupe sans blessure grave. Par exemple, en exprimant les impédances et les caractéristiques d'Impédance en ohms, la valeur cumulée de la première et de la deuxième impédance peut être choisie supérieure à 20kΩ, et de préférence supérieure à 100kΩ. L'impédance du corps et l'impédance de contact du doigt étant estimées inférieures à 10kΩ chacune.

Dans un tel cas, et en l'absence de contact du doigt avec l'organe de coupe, l'impédance du premier circuit est quasi-infinie et nettement supérieure à 20kΩ ou 100kΩ. Le choix d'une impédance plus élevée que celle résultant d'une blessure permet de sécuriser encore davantage le dispositif et d'éviter une blessure, y compris une blessure légère.

Lorsque le doigt arrive en contact avec l'organe de coupe, l'impédance du corps de l'utilisateur et du contact de son doigt sur l'organe de coupe, dans le premier circuit électrique devient alors inférieure à la valeur d'impédance de la somme de la première et de la deuxième impédance électrique du deuxième circuit électrique. Ainsi la caractéristique d'impédance mesurée du premier circuit électrique devient Inférieure à la caractéristique d'Impédance de seuil ou, pour le moins franchit la caractéristique de seuil.

On rappelle que les caractéristiques d'impédance mesurées peuvent être exprimées soue la forme d'une tension, d'un courant ou d'une valeur ohmique. Selon le cas, la valeur de seuil est franchie lorsque la caractéristique d'Impédance du premier circuit passe d'une valeur supérieure à la caractéristique de seuil à une valeur inférieure à la caractéristique de seuil (cas de la tension ou de l'impédance) ou en passant d'une valeur Inférieure à la caractéristique de seuil à une valeur supérieure à la caractéristique de seuil (cas du courant).

Il convient de noter que les valeurs de la première impédance et de la deuxième impédance électrique ne sont pas nécessairement supérieures à une valeur estimée de la somme de l'impedance du corps de l'utilisateur et de l'Impédance de contact du doigt. En effet en choisissant une caractéristique de seuil en fonction de la caractéristique d'impédance du deuxième circuit, et en particulier proportionnellement à cette caractéristique d'Impédance il est possible d'ajuster la caractéristique de seuil avec un coefficient de proportionnalité de manière à optimiser la mise en sécurité de l'outil.

Selon des modes de réalisation préférés, une ou plusieurs des caractéristiques suivantes peuvent être retenues :

- la deuxième impédance électrique présente une valeur ohmique supérieure à 20kΩ, et de préférence supérieure à 100kΩ.

- la première impédance électrique présente une valeur ohmique égale à celle de la deuxième Impédance électrique.

- la première impédance électrique et la deuxième impédance électriques sont purement résistives.

Selon une mise en œuvre préférée de l'invention, la première impédance électrique peut présenter une valeur ohmique égale à celle de la deuxième impédance électrique et supérieure à une valeur de 20kΩ, et la première caractéristique de seuil peut être choisie égale à la caractéristique d'impédance du deuxième circuit.

La mesure de la caractéristique d'impédance du premier circuit électrique et la mesure de la caractéristique d'impédance du deuxième circuit électrique ne sont pas nécessairement concomitantes mais peuvent être alternées en fonction des déclenchements de coupe. Le fait d'alterner les mesures permet notamment d'utiliser un unique dispositif de mesure pour mesurer les caractéristiques d'Impédance des deux circuits.

Dans ce cas, le deuxième circuit électrique peut comporter un interrupteur, l'interrupteur étant piloté par la commande de déclenchement de coupe pour ouvrir le deuxième circuit lors d'un déclenchement de coupe, et pour fermer le deuxième circuit en l'absence de déclenchement de coupe, le dispositif de mesure étant configuré pour mesurer une caractéristique d'impédance du premier circuit électrique lorsque le deuxième circuit est ouvert et pour mesurer une caractéristique d'impédance du deuxième circuit électrique lorsque le deuxième circuit est fermé.

Le terme "interrupteur" est compris ici de manière fonctionnelle. Il peut s'agir d'un interrupteur électromécanique ou d'un interrupteur à transistor passant d'un état conducteur à un état bloqué et inversement.

L'interrupteur est considéré comme piloté par la commande de déclenchement de coupe lorsque son ouverture est mécaniquement ou électriquement asservie à l'actionnement de la commande de déclenchement de coupe.

Dans le cas d'une mesure alternative de la caractéristique d'Impédance du premier circuit électrique et de la caractéristique d'impédance du deuxième circuit électrique, la valeur de seuil, qui est fonction de la caractéristique d'impédance du deuxième circuit électrique peut être modifiée et mise à jour à intervalles de temps réguliers et/ou à chaque nouvelle mesure de cette caractéristique d'impédance.

Aussi l'outil de coupe peut comporter une mémoire de conservation de la caractéristique de seuil. La mémoire peut être rafraichie à chaque nouvelle mesure, et la valeur conservée est fournie au comparateur.

Comme évoqué précédemment, le dispositif de mesure ne mesure pas nécessairement une impédance du premier et du deuxième circuit, mais pour le moins une caractéristique d'impédance, c'est-à-dire une caractéristique liée à l'Impédance. En particulier, le dispositif de mesure peut comporter une source de courant électrique en série avec le premier et le deuxième circuit électrique et au moins l'un parmi :

- un voltmètre connecté en parallèle aux bornes de la première impédance,
- un ampèremètre ou un ohm-mètre connecté en série en lieu et place de la première impédance.

Dans ce cas, la tension relevée par le voltmètre ou l'intensité du courant relevée par l'ampèremètre ou l'impédance relevée par l'Ohm-mètre sont utilisables comme des caractéristiques d'impédance.

La caractéristique de seuil peut être fixée de manière comparable comme étant une tension, une impédance ou un courant de seuil.

La fermeture du premier circuit électrique par un contact du doigt sur l'organe de coupe provoque, le cas échéant, une augmentation du courant traversant le premier circuit, une diminution de la tension aux bornes de la première impédance ou une diminution de la caractéristique d'impédance, et donc un franchissement de la caractéristique de seuil.

Selon un mode de réalisation perfectionné, la source de courant électrique du dispositif de mesure peut être une source de courant alternatif, il s'agit, par exemple, d'une source avec une fréquence alternative de 10 kHz. L'utilisation d'une source de courant alternatif permet d'envisager la mise en œuvre de l'invention avec un outil dont l'organe de coupe, conducteur, serait recouvert d'un revêtement isolant, pour éviter notamment la corrosion de la lame. Par exemple, la lame peut être recouverte d'un fin revêtement en PTFE de façon à faciliter son glissement sur la contre-lame lors de la coupe Le contact du doigt avec l'organe de coupe serait dans ce cas un contact majoritairement capacitif. Par exemple, si la lame de coupe est recouverte d'un revêtement protecteur de la corrosion, de salissures ou de sève, le contact est tout de même identifié. Il faut noter ici toutefois que le tranchant de la lame est affranchi de ce type de revêtement, le tranchant de la lame étant trop effilé pour qu'un tel revêtement protecteur y adhère.

L'outil de coupe peut comporter une électrode de contrôle reliée électriquement à l'organe de coupe. L'électrode de contrôle permet, dans ce cas, de simuler un contact de l'utilisateur avec l'organe de coupe, de manière à tester le bon fonctionnement du dispositif d'arrêt d'urgence sans pour autant risquer une coupure.

Par ailleurs, l'outil peut comporter un circuit de surveillance d'un potentiel électrique de l'organe de coupe de façon à confirmer sa présence dans le circuit électrique. Le dispositif d'arrêt d'urgence du moteur électrique est alors piloté par le circuit de surveillance pour provoquer un arrêt du moteur électrique lorsque le potentiel électrique de l'organe de coupe est hors d'une plage de consigne.

En particulier lorsque l'organe de coupe est normalement relié à un potentiel de masse de l'outil, le circuit de surveillance permet de détecter toute différence de potentiel non nulle entre l'organe de coupe et la masse de l'outil. Dans ce cas, on coupe l'alimentation électrique du moteur d'actionnement en réponse à la détection d'une telle différence de potentiel non nulle avec l'organe de coupe.

La surveillance du potentiel de l'organe de coupe permet d'éviter un disfonctionnement du dispositif d'arrêt d'urgence lorsque l'organe de coupe se trouve accidentellement porté à un potentiel susceptible d'affecter ou de perturber les mesures des caractéristiques d'impédance.

Le dispositif d'arrêt d'urgence, piloté par le comparateur, peut comporter au moins l'un parmi :

- un Interrupteur de coupure d'un circuit d'alimentation du moteur électrique,
- une carte électronique de commande du moteur électrique pilotant un arrêt du moteur ou un actionnement du moteur de façon à commander un mouvement d'urgence de l'organe de coupe, par exemple une rotation en sens inverse de façon à ouvrir la lame de coupe ou pour annuler l'inertie des pièces en mouvement lors de la coupe,
- un interrupteur de coupure de la commande de déclenchement d'une opération de coupe, et
- un frein d'urgence de l'organe de coupe, agissant, par exemple, directement sur l'organe de coupe.

Le frein peut être un frein à commande électromagnétique.

Dans une réalisation préférée, le moteur électrique peut être géré par une carte électronique de commande. La carte permet de déterminer la rotation du moteur et notamment le sens de rotation gouvernant une ouverture ou une fermeture de l'organe de coupe. La carte électronique peut recevoir directement le signal du comparateur ou peut intégrer le comparateur de manière à piloter une immobilisation extrêmement rapide du moteur, un freinage du moteur ou un pilotage du moteur pour compenser l'inertie des pièces en coure de mouvement et donc de l'organe de coupe en cas de franchissement de la caractéristique de seuil décrite précédemment.

Dans le cas d'un sécateur, sachant que le temps pour que la lame passe de la position ouverte à la position fermée est de l'ordre de 250 ms, le dispositif d'arrêt d'urgence est de préférence dimensionné pour pouvoir immobiliser la lame ou inverser son mouvement dans un temps inférieur à 10 millisecondes et de préférence inférieur à 1 milliseconde. Les chaire en contact avec l'organe de coupe sont en effet suffisamment élastiques pour supporter un contact avec l'organe de coupe sans générer de blessure légère durent ce laps de temps.

L'invention concerne également un procédé de contrôle d'un outil de coupe comprenant:

- un organe de coupe conducteur électrique,
- un moteur à commande électrique d'actionnement de l'organe de coupe,
- une poignée de saisie de l'outil de coupe par la main d'un utilisateur, électriquement Isolée de l'organe de coupe et pourvue d'au moins une première électrode de contact manuel et au moins une deuxième électrode de contact manuel.

Conformément à l'Invention lorsque qu'un utilisateur saisit la poignée de saisie et touche la première et la deuxième électrode de contact manuel,

• on compare :

- une caractéristique d'impédance d'un premier circuit électrique comprenant la première électrode de contact manuel, une première impédance électrique et l'organe de coupe, et
- une caractéristique de seuil fonction d'une valeur d'impédance d'un deuxième circuit électrique comprenant la première électrode de contact manuel, la deuxième électrode de contact manuel, la première impédance électrique et une deuxième impédance électrique, et

• on provoque un arrêt d'urgence de l'outil de coupe lorsque la caractéristique d'impédance du premier circuit électrique franchit la caractéristique de seuil.

Comme évoqué précédemment, lors de l'arrêt d'urgence on peut provoquer un déclenchement immédiat de l'une des opérations suivantes :

- la coupure de l'alimentation du moteur d'actionnement,
- un freinage agissant sur le moteur d'actionnement et/ou sur l'organe de coupe,
- le déclenchement d'un mouvement d'urgence du moteur d'actionnement.

La deuxième impédance électrique est choisie de préférence avec une valeur absolue supérieure à 20k$\Omega$, et de préférence supérieure à 100k$\Omega$.

Lorsque l'organe de coupe est normalement relié à la masse de l'outil, on peut également provoquer un arrêt d'urgence du moteur d'actionnement en réponse à la détection d'un potentiel non nul sur l'organe de coupe, c'est-à-dire une différence de potentiel non nulle entre l'organe de coupe et la masse de l'outil.

Enfin, il est possible de provoquer l'un parmi un arrêt d'urgence du moteur d'actionnement et une mise hors fonctionnement du moteur d'actionnement en cas de détection d'une ouverture accidentelle du deuxième circuit électrique.

L'ouverture accidentelle du deuxième circuit électrique peut traduire le fait que la main de l'utilisateur qui saisit potentiellement la poignée de saisie n'est pas ou plus en contact simultané avec les deux électrodes de contact manuel, ce qui risque d'altérer l'établissement de la caractéristique de seuil ou risque de compromettre la détection d'un contact du doigt avec l'organe de coupe.

La mise hors fonctionnement du moteur d'actionnement, par exemple la mise hors tension dans le cas d'un moteur électrique, permet dans ce cas d'empêcher l'utilisation de l'outil.

Cette mesure permet d'éviter qu'un utilisateur portant des gants isolants électriques n'utilise l'outil et que les gants Isolants électriques empêchent ou perturbent la détection d'un contact du doigt avec l'organe de coupe.

Une ouverture accidentelle du deuxième circuit électrique se traduit par une impédance infinie de ce circuit ou un courant nul circulant dans la première impédance évoquée précédemment. Cette situation peut être détectée, par exemple, par la mesure d'une tension nulle, par un voltmètre connecté en parallèle à la première Impédance électrique, ou par la mesure d'un courant nul, par un ampèremètre connecté en série avec la première impédance électrique, alors que l'interrupteur du deuxième circuit électrique est fermé. La caractéristique de seuil peut dans ce cas être établie sur la base d'une valeur singulière et générer au niveau du comparateur un signal pour activer l'arrêt d'urgence de l'outil.

L'utilisateur peut au besoin porter des gants conducteurs électriques, notamment pour se protéger du froid. Il est Important toutefois que le contact de la main avec le gant ne génère pas de variations d'impédance significative, et notamment supérieures aux variations d'un contact direct de la main avec l'électrode de contact manuel. Des gants conducteurs ne modifient pas, dans ce cas, le fonctionnement de l'outil de l'invention et notamment ses fonctions de sécurité.

D'autres caractéristiques et avantages rassortent de la description qui suit en référence aux figures. Cette description est donnée à titre illustratif et non limitatif.

**Brève description des figures**

La figure 1, est une représentation schématique simplifiée des principales caractéristiques et fonctions d'un outil de coupe conforme à l'invention.
La figure 2, est une représentation schématique simplifiée d'un sécateur conforme à l'invention.

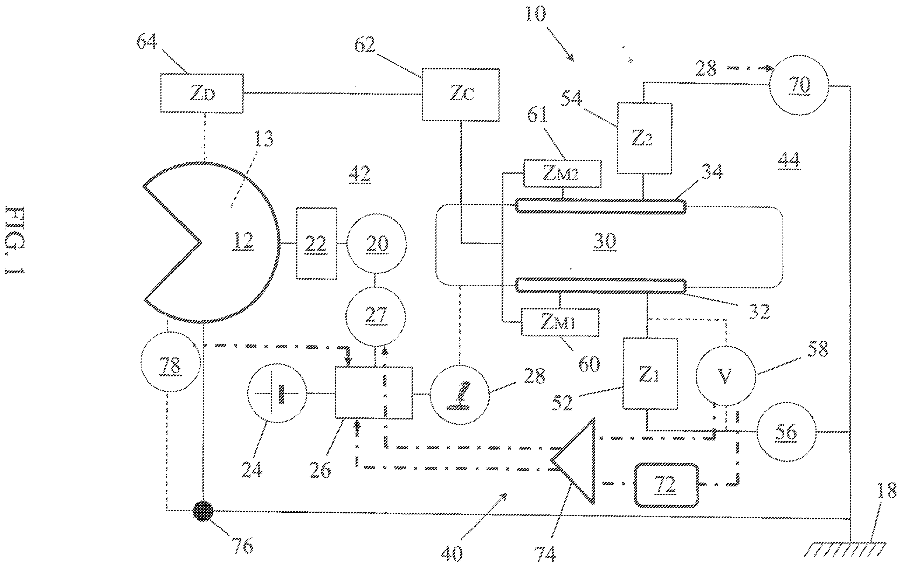

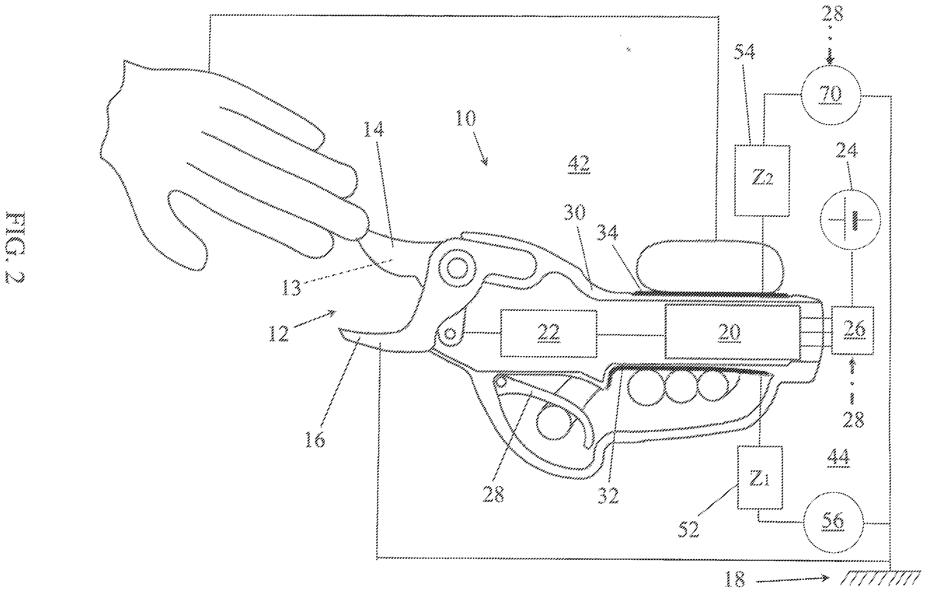

Des parties identiques ou similaires des figures 1 et 2 portent les mêmes références numériques de manière à faciliter le report d'une figure à l'autre.

**Description détaillés de modes de mise en ouvre de l'invention**

La figure 1 indique schématiquement un outil sécurisé 10 pourvu d'un organe de coupe 12. La figure 2 montre l'exemple particulier d'un sécateur électrique 10 dont l'organe de coupe est formé d'une lame mobile 14 susceptible de se refermer sur un crochet 16 et toute référence à cette construction particulière se référé à la figure 2.

La lame et le crochet sont des parties métalliques et conductrices électriques. Elles peuvent être recouvertes éventuellement d'une couche de polymère isolante électrique 13.

L'organe de coupe 12 est rellé électriquement à la masse 18 du sécateur constituant un potentiel de référence.

Le sécateur comprend en outre un moteur électrique 20 relié mécaniquement à l'organe de coupe 12, par un mécanisme de transmission 22. Dans l'exemple de la figure 2, Il fait pivoter la lame mobile 14 entre une position ouverte et une position refermée sur le crochet 16.

Le moteur est associé à une alimentation électrique 24 et à une carte électronique de commande 26 du moteur. La carte électronique de commande 26 peut recevoir des signaux d'une commande de déclenchement de coupe 28 actionnable par une main de l'utilisateur tenant une poignée de saisie 30 du sécateur électrique 10. La commande de déclenchement de coupe, par exemple une commande à gâchette comme le montre la figure 2, est disposée à proximité de la poignée de saisie 30.

La poignée de saisie est pourvue par ailleurs d'une paire d'électrodes de contact manuel 32 et 34 ménagées respectivement sur deux parties sensiblement opposées de la poignée. Les électrodes de contact manuel sont des électrodes métalliques avec lesquelles la main de l'utilisateur vient nécessairement en contact lorsque l'outil sécurisé est saisi par sa poignée. Elles sont électriquement isolées l'une de l'autre et sont électriquement Isolées de l'organe de coupe 12. La poignée de saisie 30 peut-être réalisée en matière plastique isolante à cet effet.

Un dispositif d'arrêt d'urgence 40 du moteur électrique 20 du sécateur est gouverné par deux circuits électriques 42, 44. Les circuits électriques 42, 44 incluent des composants du sécateur mais peuvent également inclure des parties du corps d'un humain utilisant le sécateur 10.

Le premier circuit électrique 42 comprend en série, un composant formant une première impédance électrique 52 une première électrode 32 de contact manuel et l'organe de coupe 12.

La première impédance électrique 52, dont la valeur est notée $Z_1$ peut être un simple composant électronique comme une résistance électrique. Sa valeur est définie de préférence égale ou supérieure à 100kΩ.

Le premier circuit électrique 42 est normalement un circuit ouvert ayant, par conséquent une Impédance globale quasi-infinie.

Lorsqu'un utilisateur saisit la poignée, sa main vient en contact des électrodes de contact manuel et donc de la première électrode de contact manuel 32. Le premier circuit électrique 42 reste ouvert.

En revanche, lorsque l'utilisateur touche également l'organe de coupe 12, par exemple avec un doigt de sa main libre, il ferme le premier circuit électrique 42. Dans ce cas, la première Impédance électrique 52 se trouve en série successivement avec la première électrode de contact manuel, une Impédance de contact 60 de la main de l'utilisateur avec la première électrode de contact manuel 32, une impédance 62 du corps de l'utilisateur, une impédance de contact 64 du doigt avec l'organe de coupe, et finalement l'organe de coupe 12.

On peut noter ici que le circuit serait aussi fermé si l'utilisateur touchait Indirectement l'organe de coupe par l'intermédiaire d'un autre organe conducteur comme une branche, un sarment de vigne voire un fil de fer de palissage qui serait en train d'être coupé par l'organe de coupe. Cette situation ne fait que rajouter une impédance supplémentaire dans le circuit et ne remet pas en cause l'Invention. Seul le cas d'un contact direct du doigt avec l'organe de coupe sera évoqué par la suite.

Les valeurs de l'impédance de contact 60 de la main, de l'impédance 62 du corps et de l'impédance de contact 64 du doigt avec l'organe de coupe sont notés respectivement $Z_{M1}$, $Z_C$ et $Z_D$.

Ainsi lorsque le premier circuit est fermé une impédance totale $Z_{42}$ est telle que :

$$Z_{42} = Z_1 + Z_{M1} + Z_C + Z_D$$

L'impédance du câblage et celle de l'organe de coupe sont négligées ici.

Un dispositif de mesure d'une caractéristique d'impédance du premier circuit électrique est prévu. Dans l'exemple de réalisation de la figure 1, Il comprend une source de courant alternatif 56 en série avec le premier circuit 42, et un voltmètre 58 connecté en parallèle avec la première Impédance 52. La valeur de tension mesurée par le voltmètre est, dans ce cas, la caractéristique d'impédance du premier circuit, au sens de l'Invention.

Un deuxième circuit électrique 44 comprend la première impédance électrique 52, la première électrode de contact manuel 32, la deuxième électrode de contact manuel 34 et une deuxième impédance électrique 54. Tout comme la première Impédance électrique, la deuxième impédance électrique peut être formée par un composant électronique comme une simple résistance d'une valeur définie de préférence supérieure à 100kΩ. Sa valeur d'impédance, qu'elle soit réelle ou complexe, est notée $Z_2$.

Le deuxième circuit électrique est également un circuit ouvert lorsque l'utilisateur ne saisit pas la poignée de saisie 30 du sécateur électrique 10. Les électrodes de contact manuel 32, 34 sont en effet électriquement isolées l'une de l'autre.

En revanche, lorsque l'utilisateur prend en main la poignée de saisie 30, sa main vient relier électriquement la première et la deuxième électrode de contact manuel 32, 34. Une impédance de contact 60 de la main de l'utilisateur avec la première électrode de contact manuel et une impédance de contact 61, d'une valeur notée $Z_{M2}$ de la main de l'utilisateur avec la deuxième électrode de contact manuel viennent alors s'ajouter en série dans le deuxième circuit.

Dans ce cas l'impédance $Z_{44}$ du deuxième circuit électrique 44 est telle que :

$$Z_{44} = Z_1 + Z_2 + Z_{M1} + Z_{M2}$$

Or, les valeurs $Z_{M1}$ et $Z_{M2}$ sont Issues de contacts de même nature et leurs variations sont donc similaires. Il en est de même de la valeur de $Z_D$ dans le premier circuit et chaque circuit comporte ainsi deux valeurs d'Impédance de contact de même nature. Une comparaison de $Z_{42}$ et $Z_{44}$ permet alors de s'affranchir des variations des impédances de contact avec les électrodes de contact manuel, et de mesurer l'occurrence d'un contact du doigt de l'utilisateur avec l'organe de coupe en évaluant $Z_C$ et $Z_D$ en regard de $Z_2$ et $Z_{M2}$.

Un dispositif de mesure est également prévu pour établir une caractéristique d'impédance du deuxième circuit électrique. Il s'agit, dans l'exemple de réalisation décrit, de la source de courant alternatif 56 et du voltmètre 58 déjà mentionnés et utilisés également en lien avec le premier circuit électrique 42. La tension mesurée aux bornes de la première impédance électrique 52 est une valeur de la caractéristique du deuxième circuit électrique 44.

Comme un unique dispositif de mesure est prévu pour mesurer les caractéristiques d'impédance du premier et du deuxième circuit électrique 42, 44 une mesure alternée est prévue.

A cet effet, le deuxième circuit électrique 44 comprend un interrupteur 70 permettant d'ouvrir ou de fermer le deuxième circuit électrique. L'interrupteur 70 peut être du type électromécanique, ou, de préférence, un interrupteur électronique à transistor.

L'interrupteur 70 est asservi à la commande de déclenchement de coupe 28 de manière à être fermé en l'absence de commande de coupe et de manière à être ouvert en cas d'une commande de coupe.

En l'absence de commande de coupe, le risque de coupure de l'utilisateur par l'organe de coupe est inexistant. Le premier circuit est ouvert en supposant que l'utilisateur ne touche pas l'organe de coupe. L'Interrupteur 70 du deuxième circuit est alors fermé et permet une mesure de la caractéristique du deuxième circuit électrique 44. Une caractéristique électrique de valeur singulière peut toutefois être mesurée dans le cas où l'utilisateur ne touche pas simultanément les deux électrodes de contact manuel, et donc quand le circuit 44 est ouvert malgré la fermeture de l'interrupteur 70.

Lorsque l'utilisateur actionne le fonctionnement de l'organe de coupe, par exemple, par l'enfoncement d'une gâchette reliée à la commande de déclenchement de coupe 28, l'Interrupteur 70 du deuxième circuit électrique 44 est ouvert de manière à permettre une mesure de la caractéristique d'Impédance du premier circuit électrique 42.

A chaque mesure de la caractéristique d'Impédance du deuxième circuit électrique 44, la valeur de cette caractéristique d'impédance, ou une valeur proportionnelle à la caractéristique d'impédance est mise à jour et conservée dans une mémoire 72 jusqu'à une prochaine mesure. Les mesures de la caractéristique d'Impédance du deuxième circuit électrique 44, et la mise à jour de la mémoire 72 peuvent être effectuées à chaque fermeture de l'interrupteur 70 du deuxième circuit électrique, ou à intervalles de temps prédéterminée lorsque ledit Interrupteur reste fermé.

La valeur mémorisée constitue une caractéristique de seuil.

La mémoire 72 est reliée à une entrée d'un comparateur 74 de manière à fournir la caractéristique de seuil comme valeur de référence.

Une deuxième entrée du comparateur 74 reçoit la caractéristique d'impédance du premier circuit électrique lors d'un déclenchement de coupe, c'est-à-dire lorsque l'Interrupteur 70 du deuxième circuit électrique 44 est ouvert.

La caractéristique d'Impédance du premier circuit électrique est ainsi comparée à la valeur de seuil.

Une sortie du comparateur 74 est reliée à la carte électronique de commande 26 du moteur 20. En cas de dépassement de la valeur de seuil par valeur supérieure ou inférieure, selon la caractéristique d'Impédance choisie, le comparateur émet un signal en direction de la carte électronique de commande du moteur. Le comparateur peut aussi émettre un tel signal en cas de présence d'une valeur singulière dans la mémoire 72, signifiant un défaut de maintient simultané des deux électrodes de contact manuel et occultant ainsi la possibilité de détection d'un contact entre le doigt et l'organe de coupe. Le signal est utilisé par la carte électronique pour déclencher un arrêt d'urgence du moteur et de l'opération de coupe. L'arrêt d'urgence peut comporter, par exemple, une ouverture d'un circuit d'alimentation électrique du moteur, ou un pilotage du moteur pour bloquer le mouvement de l'organe de coupe.

La carte électronique de commande 26 du moteur fait ainsi partie du dispositif d'arrêt d'urgence 40. Le dispositif d'arrêt d'urgence peut aussi comporter un interrupteur 27 d'ouverture d'un circuit d'alimentation électrique du moteur.

Dans une réalisation particulièrement simple de l'outil de coupe, la première impédance électrique 52 et la deuxième impédance électrique 54 peuvent être fixées à une même valeur $Z_1 = Z_2$, de l'ordre de 100k$\Omega$ ou 200k$\Omega$. Ces valeurs sont nettement supérieures à une impédance estimée du corps humain et à une impédance estimée de contact du doigt avec l'organe de coupe.

Une impédance du corps humain est estimée inférieure à 10k$\Omega$. Il en va de même de l'impédance du doigt avec l'organe coupe qui est estimée inférieure à 10k$\Omega$, et plutôt d'un ordre de grandeur de 1k$\Omega$, notamment suite à une blessure naissante.

Dans cet exemple de réalisation, la caractéristique de seuil $Z_{seuil}$ retenue est directement l'impédance mesurée du deuxième circuit, soit :

$$Z_{seuil} = Z_{44} = Z_1 + Z_2 + Z_{M1} + Z_{M2},$$

Lorsque le premier circuit électronique est ouvert, son impédance $Z_{42}$ est quasi infinie et $X_{42} > Z_{seuil}$

En revanche, lorsque l'utilisateur tenant la poignée touche simultanément l'organe de coupe, l'impédance du premier circuit électrique devient :

$$Z_{42} = Z_1 + Z_{M1} + Z_C + Z_D$$

Le comparateur 74 compare ainsi: $Z_1 + Z_{M1} + Z_C + Z_D$ et $Z_1 + Z_{M1} + Z_{M2} + Z_2$.

En éliminant $Z_1$ et $Z_{M1}$ dans les deux impédances totales, ceci revient à comparer la somme de l'Impédance du corps de l'utilisateur et de l'impédance de contact avec l'organe de coupe à l'Impédance électrique $Z_2$, majorée d'une valeur $Z_{M2}$.

Ainsi, comme $Z_2$ est choisie supérieure à la somme des valeurs estimées de $Z_C$ et $Z_D$, la somme $Z_{M2} + Z_2$ est supérieure à la somme de $Z_C$ et $Z_D$ et on a alors: $Z_{42} < Z_{seuil}$

Le seuil est franchi et le comparateur délivre un signal d'arrêt d'urgence.

La référence 76 désigne une électrode de contrôle reliée électriquement à l'organe de coupe 12. Elle est prévue pour permettre un test de l'arrêt d'urgence sans toucher l'organe de coupe. Il suffit en effet que l'utilisateur, saisissant la poignée 30, touche simultanément avec sa main libre l'électrode de contrôle 76 pour provoquer un arrêt d'urgence. La carte électronique de commande 26 peut éventuellement être configurée pour requérir une telle opération de contrôle périodique, de manière à garantir le bon fonctionnement du dispositif d'arrêt d'urgence.

Un circuit de surveillance 78 du potentiel de l'organe de coupe est également prévu. Il est construit autour d'un voltmètre et est relié également à la carte électronique de commande 26 du moteur électrique 20 pour provoquer un arrêt d'urgence lorsqu'un potentiel électrique de l'organe de coupe devient différent d'une valeur de consigne. Dans l'exemple de réalisation illustré, on vérifie que le potentiel électrique de l'organe de coupe est au potentiel de référence de l'outil.

La figure 2 montre un sécateur schématisé, avec une coupe partielle laissant apparaître le moteur électrique 20 d'entrainement de l'organe de coupe 12, ainsi que le mécanisme de transmission 22 entre le moteur 12 et la lame mobile 14.

La figure 2 illustre le contact de la main avec les électrodes de contact manuel 32 et 34 lorsque l'utilisateur saisit la poignée de saisie 30 pour une utilisation fonctionnelle du sécateur. On peut noter que les doigts et plus précisément le majeur, l'annulaire et l'auriculaire viennent en contact avec la première électrode de contact manuel 32 du premier circuit électrique 42.

La première électrode de contact manuel 32 est ici disposée sur une partie inférieure de la poignée de saisie 30, dans une position d'utilisation du sécateur.

Une partie de la paume vient en contact avec la deuxième électrode de contact manuel 34 disposée ici sur une partie supérieure de la poignée de saisie 30.

L'index de la main est libre pour actionner un organe de commande 26 qui est ici constitué par une gâchette de commande de déclenchement de l'organe de coupe.

Le pouce, situé en avant plan de la section et refermé sur la poignée pour une bonne saisie de l'outil n'est pas représenté.

La main libre de l'utilisateur est montrée dans une position où un doigt vient en contact avec la lame mobile 14 de l'organe de coupe 12. La main tenant la poignée de saisie du sécateur 10 et la main venant en contact avec l'organe de coupe sont reliées par un trait symbolisant le corps humain.

La carte électronique de commande 26 du moteur électrique est reliée au moteur électrique 20 par trois fils. Il s'agit ici d'une commande triphasée. Elle peut être utilisée pour commander la rotation du moteur dans un sens provoquant la fermeture de la lame mobile 14 sur le crochet 16. Elle peut aussi être utilisée, lors d'un arrêt d'urgence, dans un sens de rotation inverse, provoquant l'ouverture de l'organe de coupe, et contrant sa fermeture. Enfin. elle peut être utilisée comme frein électromagnétique, par exemple en mettant en court-circuit les phases du moteur.

La carte électronique de commande est, par ailleurs reliée à une alimentation électrique 24, telle qu'une batterie électrique portée, par exemple, au dos de l'utilisateur.

## Revendications

1. Outil de coupe sécurisé (10) comprenant

- un organe de coupe (12) conducteur électrique,
- un moteur (20) d'actionnement de l'organe de coupe (12), commandé électriquement,
- une poignée (30) de saisie de l'outil de coupe (10) par la main d'un utilisateur, la poignée de saisie étant électriquement isolée de l'organe de coupe,
- une commande de déclenchement de coupe (28) actionnable par la main de l'utilisateur saisissant la poignée de saisie, la commande de déclenchement de coupe étant électriquement isolée de l'organe de coupe,
- un dispositif d'arrêt d'urgence (40) sensible à un contact d'un utilisateur avec l'organe de coupe,

**caractérisé par** :

- au moins une première et au moins une deuxième d'électrode de contact manuel (32, 34), la première électrode de contact manuel et la deuxième électrode de contact manuel étant électriquement Isolées l'une de l'autre et ménagées sur au moins l'une de la poignée (30) de saisie de l'outil et la commande de déclenchement de coupe (28),
- un premier circuit électrique (42) comprenant la première électrode de contact manuel (32), une première impédance électrique (52) et l'organe de coupe (12), le premier circuit électrique (42) étant susceptible d'être fermé, lors d'un contact simultané de l'utilisateur avec ladite première électrode de contact manuel (32) et l'organe de coupe (12),
- un deuxième circuit électrique (44) comprenant la première et la deuxième électrode de contact manuel (32, 34), la première impédance électrique (52) et une deuxième impédance électrique (54), le deuxième circuit électrique étant susceptible (44) d'être fermé lors d'un contact simultané de l'utilisateur avec la première et la deuxième électrode de contact manuel (32, 34),
- au moins un dispositif (56, 58) de mesure d'une caractéristique d'impédance du premier circuit électrique (42) et d'une caractéristique d'impédance du deuxième circuit électrique (44),
- un comparateur (74) de la caractéristique d'impédance du premier circuit électrique et d'au moins une caractéristique de seuil fonction de la caractéristique d'impédance du deuxième circuit électrique, le comparateur (74) étant relié au dispositif d'arrêt d'urgence (40), pour provoquer un arrêt d'urgence de l'outil de coupe en cas de franchissement de la caractéristique de seuil.

2. Outil de coupe selon la revendication 1 dans lequel le deuxième circuit électrique (44) comprend un interrupteur (70), l'interrupteur étant piloté par la commande de déclenchement de coupe (28) pour ouvrir le deuxième circuit lors d'un déclenchement de coupe, et pour fermer le deuxième circuit en l'absence de déclenchement de coupe, le dispositif de mesure (56, 58) étant configuré pour mesurer une caractéristique d'impédance du premier circuit électrique (42) lorsque le deuxième circuit électrique (44) est ouvert et pour mesurer une caractéristique d'impédance du deuxième circuit électrique (44) lorsque le deuxième circuit électrique (44) est fermé.

3. Outil de coupe selon la revendication 1, dans lequel le dispositif de mesure comprend une source de courant électrique (56) en série avec le premier et le deuxième circuit électrique et au moins l'un parmi

   - un voltmètre (58) connecté en parallèle aux bornes de la première résistance électrique,
   - un ampèremètre, ou un ohm-mètre, connecté en série avec la première résistance électrique.

4. Outil de coupe selon la revendication 3, dans lequel la source de courant électrique (56) est une source de courant alternatif.

5. Outil de coupe selon l'une quelconque des revendications précédentes, dans lequel la première Impédance électrique (52) présente une valeur ohmique ($Z_1$) égale à la valeur ohmique ($Z_2$) de la deuxième Impédance électrique, et supérieure à 20kΩ, et dans lequel la caractéristique de seuil est égale à la caractéristique d'impédance du deuxième circuit.

6. Outil de coupe selon l'une quelconque des revendications précédentes, comprenant une mémoire (72) de conservation de la caractéristique de seuil.

7. Outil de coupe selon l'une quelconque des revendications précédentes, comprenant une électrode de contrôle (76) rellée électriquement à l'organe de coupe (12).

8. Outil de coupe selon l'une quelconque des revendications précédentes, comprenant un circuit de surveillance (78) d'un potentiel électrique de l'organe de coupe, le dispositif d'arrêt d'urgence (40) du moteur électrique étant en outre piloté par le circuit de surveillance pour provoquer un arrêt du moteur électrique lorsque le potentiel électrique de l'organe de coupe est hors d'une plage de consigne.

9. Outil de coupe selon l'une quelconque des revendications précédentes dans lequel le dispositif d'arrêt d'urgence (40) comprend au moins l'un parmi :

   - un interrupteur (27) de coupure d'un circuit d'alimentation du moteur électrique,
   - une carte électronique (26) de commande du moteur électrique (20), et
   - un interrupteur de coupure de la commande de déclenchement d'une opération de coupe, et
   - un frein d'urgence de l'organe de coupe.

10. Outil de coupe selon l'une quelconque des revendications précédentes, dans lequel la première électrode de contact manuel (32) et la deuxième électrode de contact manuel (34) sont disposée sur des côtés opposés de la poignée de saisie (30).

11. Outil de coupe selon l'une quelconque des revendications précédentes, dans lequel la deuxième impédance électrique (54) présente une valeur ohmique supérieure à 20kΩ, et de préférence supérieure à 100kΩ.

12. Outil de coupe selon l'une quelconque des revendications précédentes dans lequel la première impédance électrique (52) présente une valeur ohmique égale à celle de la deuxième impédance électrique (54).

13. Outil de coupe selon l'une quelconque des revendications précédentes, l'outil de coupe étant l'un parmi un sécateur et une cisaille.

14. Procédé de contrôle d'un outil de coupe comprenant :

    - un organe de coupe (12) conducteur électrique,
    - un moteur à commande électrique (20) d'actionnement de l'organe de coupe,
    - une poignée de saisis (30) de l'outil de coupe par la main d'un utilisateur, électriquement isolée de l'organe de coupe et pourvue d'au moins une première électrode de contact manuel (32) et au moins une deuxième électrode de contact manuel (34), dans lequel, lorsque qu'un utilisateur saisit la poignée de saisis et touche la première et la deuxième électrode de de contact manuel,

      • on compare :

        - une caractéristique d'impédance d'un premier circuit électrique (42) comprenant la première électrode de contact manuel (32), une première impédance électrique (52) et l'organe de coupe (12), et
        - une caractéristique de seuil fonction d'une valeur d'Impédance d'un deuxième circuit électrique (44) comprenant la première électrode de contact manuel (32), la deuxième électrode de contact manuel (34), la première impédance électrique (52) et une deuxième Impédance électrique (54), et

      • on provoque un arrêt d'urgence de l'outil de coupe lorsque la caractéristique d'impédance du premier circuit électrique franchit la caractéristique de seuil.

**15.** Procédé de contrôle selon la revendication 14, dans lequel on provoque en outre un arrêt d'urgence du moteur d'actionnement en réponse à la détection d'un potentiel de tension non nul sur l'organe de coupe (12).

**16.** Procédé de contrôle selon la revendication 14, dans lequel lors de l'arrêt d'urgence on provoque un déclenchement immédiat de l'une des opérations suivantes :

- la coupure de l'alimentation du moteur d'actionnement,
- un freinage agissant sur le moteur d'actionnement et/ou sur l'organe de coupe,
- le déclenchement d'un mouvement d'urgence du moteur d'actionnement.

**17.** Procédé de contrôle selon la revendication 14 dans lequel on provoque en outre l'un parmi un arrêt d'urgence du moteur d'actionnement et une mise hors fonctionnement du moteur d'actionnement, en cas de détection d'une ouverture accidentelle du deuxième circuit électrique (44).

**Patentansprüche**

**1.** Gesichertes Schneidwerkzeug (10), umfassend

- ein elektrisches, leitendes Schneidorgan (12),
- einen Motor (20) zur Betätigung des Schneidorgans (12), der elektrisch gesteuert ist,
- einen Griff (30) zum Halten des Schneidorgans (10) mit der Hand eines Benutzers, wobei der Griff zum Halten von dem Schneidorgan elektrisch isoliert ist,
- eine Schneidauslösesteuerung (28), die mit der Hand des Benutzers, der den Griff zum Halten hält, betätigbar ist, wobei die Schneidauslösesteuerung von dem Schneidorgan elektrisch isoliert ist,
- eine Nothaltvorrichtung (40), die auf einen Kontakt eines Benutzers mit dem Schneidorgan reagiert, **gekennzeichnet durch**:
- wenigstens eine erste und wenigstens eine zweite Handkontaktelektrode (32, 34), wobei die erste Handkontaktelektrode und die zweite Handkontaktelektrode voneinander elektrisch isoliert sind und auf wenigstens einem von dem Griff (30) zum Halten des Werkzeugs und der Schneidauslösesteuerung (28) eingerichtet sind,
- einen ersten elektrischen Kreis (42), der die erste Handkontaktelektrode (32), eine erste elektrische Impedanz (52) und das Schneidorgan (12) umfasst, wobei der erste elektrische Kreis (42) imstande ist, bei einem gleichzeitigen Kontakt des Benutzers mit der ersten Handkontaktelektrode (32) und dem Schneidorgan (12) geschlossen zu werden,
- einen zweiten elektrischen Kreis (44), der die erste und die zweite Handkontaktelektrode (32, 34), die erste elektrische Impedanz (52) und eine zweite elektrische Impedanz (54) umfasst, wobei der zweite elektrische Kreis (44) imstande ist, bei einem gleichzeitigen Kontakt des Benutzers mit der ersten und der zweiten Handkontaktelektrode (32, 34) geschlossen zu werden,
- wenigstens eine Vorrichtung (56, 58) zur Messung eines Impedanzcharakteristikums des ersten elektrischen Kreises (42) und eines Impedanzcharakteristikums des zweiten elektrischen Kreises (44),
- einen Komparator (74) des Impedanzcharakteristikums des ersten elektrischen Kreises und wenigstens eines Grenzcharakteristikums, das abhängig ist von dem Impedanzcharakteristikum des zweiten elektrischen Kreises, wobei der Komparator (74) mit der Nothaltvorrichtung (40) verbunden ist, um einen Nothalt des Schneidwerkzeugs im Fall einer Übertretung des Grenzcharakteristikums hervorzurufen.

**2.** Schneidwerkzeug nach Anspruch 1, wobei der zweite elektrische Kreis (44) einen Schalter (70) umfasst, wobei der Schalter von der Schneidauslösesteuerung (28) gesteuert wird, um den zweiten Kreis bei einer Schneidauslösung zu öffnen und um den zweiten Kreis in Abwesenheit einer Schneidauslösung zu schließen, wobei die Vorrichtung zur Messung (56, 58) ausgestaltet ist, ein Impedanzcharakteristikum des ersten elektrischen Kreises (42) zu messen, wenn der zweite elektrische Kreis (44) offen ist, und ein Impedanzcharakteristikum des zweiten elektrischen Kreises (44) zu messen, wenn der zweite elektrische Kreis (44) geschlossen ist.

**3.** Schneidwerkzeug nach Anspruch 1, wobei die Vorrichtung zur Messung eine elektrische Stromquelle (56) in Reihenschaltung mit dem ersten und dem zweiten elektrischen Kreis und wenigstens eines von Folgendem umfasst:

- ein Voltmeter (58), das in Parallelschaltung an die Klemmen des ersten elektrischen Widerstands angeschlossen ist,
- ein Amperemeter oder ein Ohmmeter, das in Reihenschaltung mit dem ersten elektrischen Widerstand verbunden ist.

**4.** Schneidwerkzeug nach Anspruch 3, wobei die elektrische Stromquelle (56) eine Wechselstromquelle ist.

**5.** Schneidwerkzeug nach einem der vorstehenden Ansprüche, wobei die erste elektrische Impedanz (52) einen Widerstandswert ($Z_1$) aufweist, der gleich dem Widerstandswert ($Z_2$) der zweiten elektrischen Impedanz und größer als 20 kΩ ist, und wobei das Grenzcharakteristikum gleich dem Impedanzcharakteristikum des zweiten Kreises ist.

6. Schneidwerkzeug nach einem der vorstehenden Ansprüche, umfassend einen Speicher (72) zur Bewahrung des Grenzcharakteristikums.

7. Schneidwerkzeug nach einem der vorstehenden Ansprüche, umfassend eine Kontrollelektrode (76), die mit dem Schneidorgan (12) elektrisch verbunden ist.

8. Schneidwerkzeug nach einem der vorstehenden Ansprüche, umfassend einen Überwachungskreis (78) eines elektrischen Potentials des Schneidorgans, wobei die Nothaltvorrichtung (40) des Elektromotors weiter von dem Überwachungskreis gesteuert wird, um einen Halt des Elektromotors hervorzurufen, wenn das elektrische Potential des Schneidorgans außerhalb eines Sollbereichs liegt.

9. Schneidwerkzeug nach einem der vorstehenden Ansprüche, wobei die Nothaltvorrichtung (40) wenigstens eines von Folgendem umfasst:

   - einen Schalter (27) zur Unterbrechung eines Versorgungskreises des Elektromotors,
   - eine elektronische Karte (26) zur Steuerung des Elektromotors (20) und
   - einen Schalter zur Unterbrechung der Auslösesteuerung eines Schneidvorgangs und
   - eine Notbremse des Schneidorgans.

10. Schneidwerkzeug nach einem der vorstehenden Ansprüche, wobei die erste Handkontaktelektrode (32) und die zweite Handkontaktelektrode (34) auf gegenüberliegenden Seiten des Griffs zum Halten (30) angeordnet sind.

11. Schneidwerkzeug nach einem der vorstehenden Ansprüche, wobei die zweite elektrische Impedanz (54) einen Widerstandswert größer als 20 kΩ und vorzugsweise größer als 100 kΩ aufweist.

12. Schneidwerkzeug nach einem der vorstehenden Ansprüche, wobei die erste elektrische Impedanz (52) einen Widerstandswert gleich jenem der zweiten elektrischen Impedanz (54) aufweist.

13. Schneidwerkzeug nach einem der vorstehenden Ansprüche, wobei das Schneidwerkzeug eines von einer Astschere und einer Gartenschere ist.

14. Verfahren zur Kontrolle eines Schneidwerkzeugs, umfassend:

   - ein elektrisches, leitendes Schneidorgan (12),
   - einen Motor mit elektrischer Steuerung (20) zur Betätigung des Schneidorgans,
   - einen Griff zum Halten (30) des Schneidorgans mit der Hand eines Benutzers, der von dem Schneidorgan elektrisch isoliert ist und mit wenigstens einer ersten Handkontaktelektrode (32) und wenigstens einer zweiten Handkontaktelektrode (34) versehen ist, wobei, wenn ein Benutzer den Griff zum Halten festhält und die erste und die zweite Handkontaktelektrode berührt,

      • verglichen wird:

         - ein Impedanzcharakteristikum eines ersten elektrischen Kreises (42), der die erste Handkontaktelektrode (32), eine erste elektrische Impedanz (52) und das Schneidorgan (12) umfasst, und
         - ein Grenzcharakteristikum, das abhängig ist von einem Impedanzwert eines zweiten elektrischen Kreises (44), der die erste Handkontaktelektrode (32), die zweite Handkontaktelektrode (34), die erste elektrische Impedanz (52) und eine zweite elektrische Impedanz (54) umfasst, und

      • ein Nothalt des Schneidwerkzeugs hervorgerufen wird, wenn das Impedanzcharakteristikum des ersten elektrischen Kreises das Grenzcharakteristikum übersteigt.

15. Verfahren zur Kontrolle nach Anspruch 14, wobei weiter ein Nothalt des Motors zur Betätigung in Antwort auf die Erkennung eines Spannungspotentials, das nicht null ist, am Schneidorgan (12) hervorgerufen wird.

16. Verfahren zur Kontrolle nach Anspruch 14, wobei bei dem Nothalt eine sofortige Auslösung eines der folgenden Vorgänge hervorgerufen wird:

   - die Unterbrechung der Versorgung des Motors zur Betätigung,
   - eine Bremsung, die auf den Motor zur Betätigung und/oder auf das Schneidorgan einwirkt,
   - die Auslösung einer Notbewegung des Motors zur Betätigung.

17. Verfahren zur Kontrolle nach Anspruch 14, wobei weiter eines von einem Nothalt des Motors zur Betätigung und einer Abschaltung des Motors zur Betätigung im Fall einer Erkennung einer zufälligen Öffnung des zweiten elektrischen Kreises (44) hervorgerufen wird.

## Claims

1. Secure cutting tool (10) comprising

   - an electrically conductive cutting member (12),
   - a motor (20) for actuating the cutting member (12), electrically controlled,
   - a handle (30) for gripping the cutting tool (10) by the hand of a user, the gripping handle being electrically insulated from the cutting member,
   - a control for triggering cutting (28) actuatable by the hand of the user gripping the gripping handle, the control for triggering cutting being electrically insulated from the cutting member,
   - an emergency stop device (40) sensitive to a contact of a user with the cutting member,
   - **characterised by**:

     - at least one first and at least one second electrode for manual contact (32, 34), the first electrode for manual contact and the second electrode for manual contact being electrically insulated from one another and created on at least one out of the handle (30) for gripping the tool and the control for triggering cutting (28),
     - a first electric circuit (42) comprising the first electrode for manual contact (32), a first electric impedance (52) and the cutting member (12), the first electric circuit (42) being capable of being closed, during a simultaneous contact of the user with said first electrode for manual contact (32) and the cutting member (12),
     - a second electric circuit (44) comprising the first and the second electrode for manual contact (32, 34), the first electric impedance (52) and a second electric impedance (54), the second electric circuit being capable (44) of being closed during a simultaneous contact of the user with the first and the second electrode for manual contact (32, 34),
     - at least one device (56, 58) for measuring an impedance characteristic of the first electric circuit (42) and an impedance characteristic of the second electric circuit (44),
     - a comparator (74) of the impedance characteristic of the first electric circuit and of at least one threshold characteristic that is a function of the impedance characteristic of the second electric circuit, the comparator (74) being connected to the emergency stop device (40) to trigger an emergency stoppage of the cutting tool in case the threshold characteristic is exceeded.

2. Cutting tool according to claim 1, wherein the second electric circuit (44) comprises a switch (70), the switch being controlled by the control for triggering cutting (28) to open the second circuit during a triggering of cutting, and to close the second circuit in the absence of triggering of cutting, the measurement device (56, 58) being configured to measure an impedance characteristic of the first electric circuit (42) when the second electric circuit (44) is open and to measure an impedance characteristic of the second electric circuit (44) when the second electric circuit (44) is closed.

3. Cutting tool according to claim 1, wherein the measurement device comprises a source of electric current (56) in series with the first and the second electric circuit and at least one out of:

   - a voltmeter (58) connected in parallel to the terminals of the first electric resistor,
   - an ammeter, or an ohmmeter, connected in series with the first electric resistor.

4. Cutting tool according to claim 3, wherein the source of electric current (56) is a source of alternating current.

5. Cutting tool according to any one of the previous claims, wherein the first electric impedance (52) has an ohmic value ($Z_1$) equal to the ohmic value ($Z_2$) of the second electric impedance, and greater than 20kΩ, and wherein the threshold characteristic is equal to the impedance characteristic of the second circuit.

6. Cutting tool according to any one of the previous claims, comprising a memory (72) for preserving the threshold characteristic.

7. Cutting tool according to any one of the previous claims, comprising a control electrode (76) electrically connected to the cutting member (12).

8. Cutting tool according to any one of the previous claims, comprising a circuit (78) for monitoring an electric potential of the cutting member, the device (40) for emergency stoppage of the electric motor being further controlled by the monitoring circuit to cause a stoppage of the electric motor when the electric potential of the cutting member is outside of a setting range.

9. Cutting tool according to any one of the previous claims, wherein the emergency stop device (40) comprises at least one out of:

   - a switch (27) for cutting off a power supply circuit of the electric motor,
   - an electronic card (26) for controlling the electric motor (20), and
- a switch for cutting off the control for triggering a cutting operation, and
- an emergency brake of the cutting member.

10. Cutting tool according to any one of the previous claims, wherein the first electrode for manual contact (32) and the second electrode for manual contact (34) are disposed on opposite sides of the gripping handle (30).

11. Cutting tool according to any one of the previous claims, wherein the second electric impedance (54) has an ohmic value greater than 20kΩ, and preferably greater than 100kΩ.

12. Cutting tool according to any one of the previous claims, wherein the first electric impedance (52) has an ohmic value equal to that of the second electric impedance (54).

13. Cutting tool according to any one of the previous claims, the cutting tool being one out of pruners and shears.

14. Method for controlling a cutting tool comprising:

   - an electrically conductive cutting member (12),
   - an electrically controlled motor (20) for actuating the cutting member,
   - a handle (30) for gripping the cutting tool by the hand of a user, electrically insulated from the cutting member and provided with at least one first electrode for manual contact (32) and at least one second electrode for manual contact (34), wherein, when a user grips the gripping handle and touches the first and the second electrode for manual contact,

      -- the following are compared:

         - an impedance characteristic of a first electric circuit (42) comprising the first electrode for manual contact (32), a first electric impedance (52) and the cutting member (12), and
         - a threshold characteristic that is a function of an impedance value of a second electric circuit (44) comprising the first electrode for manual contact (32), the second electrode for manual contact (34), the first electric impedance (52) and a second electric impedance (54), and

      -- emergency stoppage of the cutting tool is caused when the impedance characteristic of the first electric circuit exceeds the threshold characteristic.

15. Control method according to claim 14, wherein an emergency stoppage of the actuation motor is further caused in response to the detection of a non-zero voltage potential on the cutting member (12).

16. Control method according to claim 14, wherein during the emergency stoppage an immediate triggering of one of the following operations is caused:

   - the cutting off of the power supply of the actuation motor,
   - braking acting on the actuation motor and/or on the cutting member,
   - the triggering of an emergency movement of the actuation motor.

17. Control method according to claim 14, wherein one out of an emergency stoppage of the actuation motor and a turning off of the actuation motor is further caused in the case of detection of an accidental opening of the second electric circuit (44).

FIG. 1

FIG. 2

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- FR 2712837
- FR 2779669
- FR 2831476
- FR 2838998
- FR 2848729
- FR 2963081
- FR 3001404
- EP 2490865 A
- EP 2825811 A
- US 5025175 A
- US 7365955 B